# EUROPEAN PATENT SPECIFICATION

(11) **EP 3 591 469 B1**
(45) Date of publication and mention of the grant of the patent: **26.08.2026**
(21) Application number: 19183882.0
(22) Date of filing: 02.07.2019
(51) Int. Cl.: G03F 1/40

(54) **PHOTOMASK AND METHOD OF MANUFACTURING A PHOTOMASK**
PHOTOMASKE UND VERFAHREN ZUR HERSTELLUNG EINER PHOTOMASKE
PHOTOMASQUE ET PROCÉDÉ DE FABRICATION D'UN PHOTOMASQUE

(30) Priority: 03.07.2018 DE 102018116054
(43) Date of publication of application: 08.01.2020
(73) Proprietor: Advanced Mask Technology Center GmbH & Co. KG, 01109 Dresden (DE)
(72) Inventor: Caspary, Dirk, 01109 Dresden (DE); Bahrig, Lydia, 01109 Dresden (DE)
(74) Representative: Müller Hoffmann & Partner

(56) References cited:
- US-A1- 2002 028 392
- US-A1- 2010 112 462
- US-A1- 2010 266 939
- US-B1- 6 376 131

## Description

### TECHNICAL FIELD

The present disclosure relates to the field of photolithography and, more specifically, to a photomask for the manufacture of semiconductor devices and a method for manufacturing the same.

### BACKGROUND

Lithographic photomasks (reticles) for the manufacturing of semiconductor devices typically include a transparent base substrate covered with a pattern with transparent portions, opaque portions and/or phase-shifting portions. For example, an imaging region of an EAPSM (embedded attenuated phase-shift mask) may include semi-transparent mask features that shift the phase of the passing exposure radiation by 180 degree with respect to clear regions between the semi-transparent mask features. A frame region that surrounds the imaging region may include a completely opaque structure.

Document US 2010 / 0 112 462 A1 describes non-imaging cut lines segmenting opaque blocking regions on a photomask. The non-imaging cut lines are arranged along the grid lines of a regular grid. The non-imaging cut lines are written in a second writing process after a writing process that writes the desired wafer pattern. The cut lines laterally separate discrete sections of the opaque blocking regions. Segmentation of the opaque blocking regions into discrete sections is intended to prevent damage to the opaque mask structures caused by electrostatic discharge. The critical electrostatic charge may accumulate in the opaque blocking regions during a cleaning process using a CO₂ beam.

In the image area of a photomask described in document US 2010 / 0 266 939 A1, non-imaging conductive bars (interrupting regions) connect a first conductive area within a transparent frame with a second conductive area outside the transparent frame, thereby "interrupting" the frame. The conductive bars consist of, e.g., chromium and prevent the first and second conductive areas inside and outside the transparent frame from being electrostatically charged to varying degree during electron beam writing. Document US 6 376 131 B1 describes modification of a reticle to break elongated portions of the lithographic mask pattern into relatively small segments that are separated by sub-resolution gaps. A method for generating the reticle includes combining data defining the lithographic mask pattern with data defining a grid of intersecting sub-resolution grooves. The lithographic mask pattern is formed from a layer of opaque masking material, e.g. chrome. Document US 2002 / 0 028 392 A1 refers to a process for forming a photomask with mask structures including exposed phase-shifting material.

There is an ongoing need to improve the yield and performance of photomasks used for the fabrication of semiconductor devices.

### SUMMARY

The present disclosure includes a method of forming a photomask. First layout data that describes a first mask pattern is searched for a critical mask feature, wherein the critical mask feature exceeds a critical extension. Second layout data is generated by replacing the critical mask feature in the first mask pattern with a substitutional mask structure, wherein the substitutional mask structure includes at least two segments and a non-printing gap between the segments. A photomask is formed that includes a second mask pattern described by the second layout data.

The present disclosure further relates to a photomask that includes a mask pattern including a mask structure. The mask structure includes at least two end points separated from neighboring mask features by printing gaps. The mask structure further includes at least two segments separated by a non-printing gap.

### BRIEF DESCRPTION OF THE DRAWINGS

The accompanying drawings are included to provide a further understanding of the photomask and the method of manufacturing a photomask according to the present disclosure and are incorporated in and constitute a part of this specification. The drawings illustrate embodiments of the present disclosure and together with the description serve to explain principles of the embodiments. Other embodiments and intended advantages will be readily appreciated as they become better understood by reference to the following detailed description.
FIG. 1A is a schematic vertical cross-sectional view of a portion of a photomask for illustrating a method of manufacturing a photomask according to an embodiment, after forming a resist mask for a mask pattern on a layer stack.
FIG. 1B is a schematic cross-sectional view of the photomask of FIG. 1A, after transferring the pattern of the resist mask into a second layer of the layer stack.
FIG. 1C is a schematic cross-sectional view of the photomask of FIG. 1B, after transferring the pattern of the second layer into a first layer of the layer stack.
FIG. 1D is a schematic cross-sectional view of the photomask of FIG. 1C, after depositing a photoresist layer.
FIG. 1E is a schematic cross-sectional view of the photomask of FIG. 1D, after exposure of the photoresist layer.
FIG. 1F is a schematic cross-sectional view of the photomask of FIG. 1E, during application of a developer solution.
FIG. 1G is a schematic cross-sectional view of the photomask of FIG. 1F, after forming mask features.
FIG. 2A is a schematic plan view of a photomask including a critical mask feature according to a reference example for discussing effects of the embodiments.
FIG. 2B is a schematic plan view of a photomask including a mask structure replacing the critical mask feature of FIG.2A according to an embodiment.
FIG. 2C is a schematic plan view of a photomask with a pattern described by first layout data for discussing effects of the embodiments.
FIGS. 3A-3D are schematic plan views of mask features for discussing effects of the embodiments.
FIGS. 4A-4D are schematic plan views of mask structures replacing the mask features of FIGS. 3A-3D according to embodiments.
FIG. 5 is a schematic plan view of a mask structure including optical correction features according to an embodiment.
FIG. 6 is a schematic plan view of a photomask including mask structures according to another embodiment.
FIGS. 7A-7B are schematic plan views of photomasks for discussing effects of the embodiments.

### DETAILED DESCRIPTION

In the following detailed description, reference is made to the accompanying drawings, which form a part hereof and in which are shown by way of illustrations specific embodiments in which a photomask and a method of manufacturing photomasks may be practiced. The examples are described using specific language, which should not be construed as limiting the scope of the appending claims. The drawings are not scaled and are for illustrative purposes only. Corresponding elements are designated by the same reference signs in the different drawings if not stated otherwise.

Ranges given for physical dimensions include the boundary values. For example, a range for a parameter y from a to b reads as a ≤ y ≤ b. The same holds for ranges with one boundary value like "at most" and "at least".

Main constituents of a layer or a structure from a chemical compound or from an alloy are such elements which atoms form the chemical compound or alloy. For example, molybdenum and silicon are the main constituents of a molybdenum silicon layer. Main constituents of a layer or structure from a mixture of substances are those elements that shall have a defined ratio in the mixture. For example, the main constituents of a layer obtained by co-sputtering are the elements contained in the targets used for the co-sputtering. In addition to the main constituents, layers and structures may include unintentional impurities due to process imperfections as well as intentional additives such as dopants.

According to an embodiment a method of forming a photomask includes searching first layout data, which describes a first mask pattern including a plurality of mask features, for a critical mask feature that exceeds a critical extension.

The mask features include line-shaped portions. For example a mask feature may include one single line-shaped portion or a mask feature may include several interconnected line-shaped portions, wherein longitudinal axes of directly interconnected line-shaped portions may run orthogonal to each other.

A critical mask feature includes a least two end points, wherein at each end point, a distance to a neighboring mask feature defines a printing gap. A printing gap separates mask features in a way such that at regular exposure conditions the exposure of the neighboring mask features results in separated resist structures on a target substrate. Regular exposure conditions are combinations of focus and dose values at which exposure of the reticle pattern forms the desired target pattern in a resist layer on the target substrate.

A critical mask feature may be a mask feature including a line-shaped portion exceeding a critical length. The critical length may depend on a minimum distance to a neighboring mask feature, on a distance to a center point of the photomask, and on other parameters such as orientation of the line-shaped portion, horizontal cross-sectional area of the mask feature by way of example.

If a critical mask feature is found, second layout data is generated by replacing the critical mask feature in the first mask pattern with a substitutional mask structure that includes at least two segments separated by a non-printing gap. Each segment includes a portion of the critical mask feature.

The non-printing gap results in that at the regular exposure conditions the exposure of the two segments may form a continuous resist structure in the resist layer on the target substrate such that the image of the substitutional mask structure in the resist layer on the target substrate substantially is the same as that of the critical mask feature. A width of the non-printing gap on the photomask is smaller than a nominal resolution of the exposure method. A contour of the combination of the at least two segments and the non-printing gaps between them may enclose the contour of the critical mask feature.

The second layout data may inherit the non-critical mask features from the first layout data without amendments. A photomask with a second mask pattern described by the second layout data is formed. Instead of the critical mask feature the photomask includes a substitutional mask structure that may include two or more segments separated by non-printing gaps.

Separating a long, continuous linear mask feature in an imaging region of a photomask into two or more partial features separated from each other by a non-printing gap may avoid or reduce a deformation of the mask feature during a patterning process applied to the photomask. For example, the manufacture of the photomask may include a patterning process that uses a spinning process that steadily applies a liquid on a front side of a rotating photomask. A nozzle may spray or dispense the liquid in a central region of the rotating photomask. The liquid may move outwardly to the edge of the photomask by centrifugal forces. While radially spreading outwardly, the liquid may accumulate electric charges in the mask features, e.g., by friction, wherein the amount of charges may differ from mask feature to mask feature.

An electric potential difference between neighboring mask features may result in a material transport within one of the mask features into direction of the other one of the mask features or away from it. The extent of the material transport may be a function of the effective electric field strength between the mask features which in turn is a function of the distance between the mask features and the electric potentials induced by the flowing liquid. The electric potential difference may increase with increasing length of the concerned mask features along a flow direction of the liquid and whereas the electrical field strength increases with decreasing distance between the concerned mask features.

The method identifies, in the first layout data, mask features between which during a spinning process an electric field strength may exceed a critical value. The critical value may be a threshold value, wherein starting from the threshold value a rate of the material transport significantly increases.

Then the method generates second layout data in which at least one of the concerned mask features (the critical mask feature) is replaced with a substitutional mask structure that includes at least two segments separated by a non-printing gap.

After separating one of the concerned mask features into at least two separate segments an effective electric field strength between them is reduced to below the critical value and material transport does not take place to a significant extent. The outline of the mask structure remains unbiased by material transport.

According to an embodiment, the second mask pattern may be formed from a layer stack that includes at least a first layer deposited on a first surface of a base substrate and a second layer on the first layer. The method facilitates the use of spinning methods for the removal of portions of the second layer without impact on mask features previously formed from portions of the first layer.

For example, the first layer may include a phase-shift material capable of shifting a phase of an exposure radiation passing the first layer by at least 90 degree, for example, by 180 degree, wherein a wavelength of the exposure radiation may be in a range from 146 nm to 248 nm, by way of example. The second layer may include a conductive material with a transparency of less than 10% to the exposure radiation. The base substrate may include a non-conductive material, for example glass, quartz, or ceramic. Mask features formed from the first layer or from the first and the second layer form spatially separated (isolated) and electrically insulated islands, wherein between neighboring mask features remarkable electric field strength may appear during a spinning process applying a liquid at the front side of the photomask. For example, the first layer may include molybdenum and silicon as only main constituents. The second layer may include chromium as only main constituent.

Portions of the layer stack may be removed to form a plurality of spatially and electrically separated stack features. Remnant portions of the second layer may be removed from first stack features by using a photoresist mask that covers at least one second stack feature. The second stack feature may form an opaque frame around an imaging region of the reticle.

Forming the photoresist mask may include applying a non-conductive or low-conductive liquid, wherein the liquid is applied, e.g., sprayed or dispensed in a central region of the photomask and flows in radial direction with respect to a horizontal center-point of the photomask. The liquid may come into contact with the first stack features and may cause a potential difference between neighboring mask features, wherein the electric field strength between neighboring mask features may be high enough to induce electromagnetic-forced migration of atoms in the first layer.

According to another embodiment, a photomask may include a mask pattern that includes spatially isolated and electrically insulated mask features separated from each other by printing gaps. Each mask feature includes one or more straight stripe-shaped portions. At least one of the mask features includes at least two segments and a non-printing gap separating the two segments.

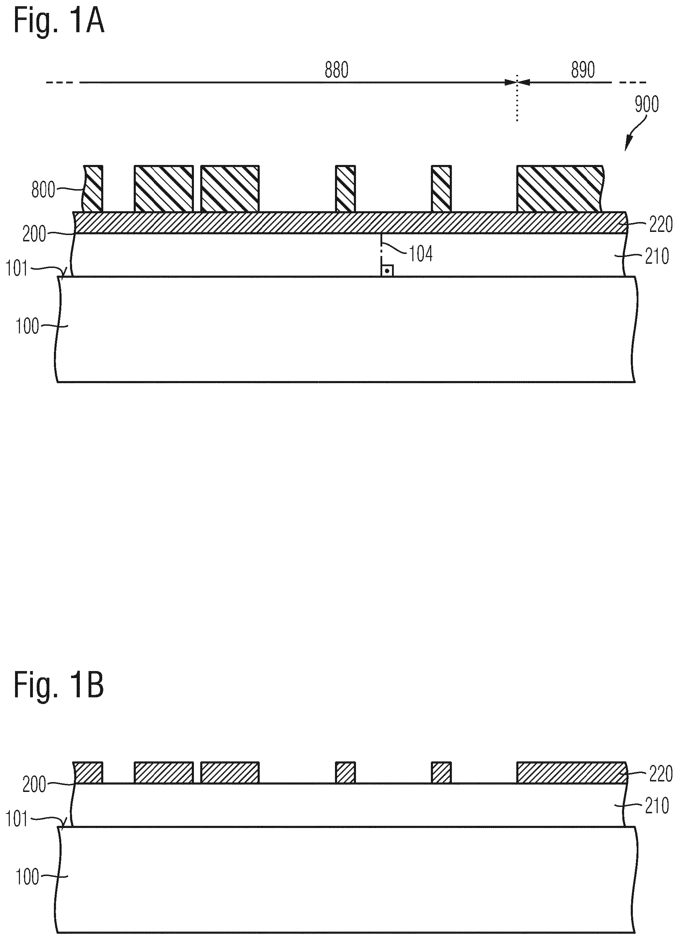

FIGS. 1A to 1G refer to a method of manufacturing a photomask 900 for the manufacture of semiconductor devices. A layer stack 200 that may include at least a first layer 210 and a second layer 220 is deposited on a base substrate 100, wherein the first layer 210 is deposited on a first surface 101 of the base substrate 100 and the second layer 220 is deposited on the first layer 210. Directions parallel to the first surface 101 are horizontal directions. A surface normal 104 to the first surface 101 defines a vertical direction.

A resist layer is deposited on the layer stack 200 and patterned. For example, the resist layer may be an electron resist layer that is patterned by electron-beam lithography, wherein an electron beam may scan across a top surface of the resist layer and locally changes the solubility of the electron resist. A developing process selectively removes either the scanned or the non-scanned portions of the resist layer, e.g., by using a solvent. A remnant portion of the resist layer forms a resist mask 800.

FIG. 1A shows the resist mask 800 exposing a first portion of the layer stack 200 in an imaging region 880 and covering a second portion of the layer stack 200 in the imaging region 880 and in a frame region 890, wherein the frame region 890 may surround the imaging region 880.

A lower first layer 210 of the layer stack 200 may include a phase-shifting material or may consist of a phase-shifting material, wherein the phase-shifting material may shift the phase of an exposure radiation having an exposure wavelength by at least 90 degree, for example by 180 degree. The exposure radiation images a finalized photomask pattern into a photoresist layer on a target substrate. The exposure wavelength of the exposure radiation may be in a range from 100 nm to 300 nm. For example, the exposure wavelength may be 248 nm, 193 nm, 157 nm, or 146 nm.

The first layer 210 is transparent to the exposure radiation to a sufficient degree. For example, at the exposure wavelength the first layer 210 may have a transmittance of at least 1%, for example 5%. Main constituents of the first layer 210 may be molybdenum and silicon. For example, the first layer 210 may contain or consist of silicided molybdenum (MoSi).

An upper second layer 220 of the layer stack 200 may be more opaque for the exposure radiation than the first layer 210. For example, the light transmittance of the second layer 220 at the exposure wavelength may be less than 1%. According to an embodiment, the second layer 220 may consist of or at least include chromium as only main constituent. The base substrate 100 be highly transparent at the exposure radiation. For example the base substrate 100 may include silicon and oxygen, for silicon oxide, glass or quartz.

The resist mask 800 defines a mask pattern which the exposure radiation images into a photoresist layer deposited on a target substrate, e.g., a semiconductor wafer. An etch process images the pattern of the resist mask 800 into the second layer 220. The resist mask 800 may be removed.

FIG. 1B shows the patterned second layer 220 after removal of the resist mask 800. A further etch process, e.g. a dry etch may transfer the pattern of the second layer 220 into the first layer 210 at high pattern fidelity, wherein the patterned second layer 220 may be used as etch mask.

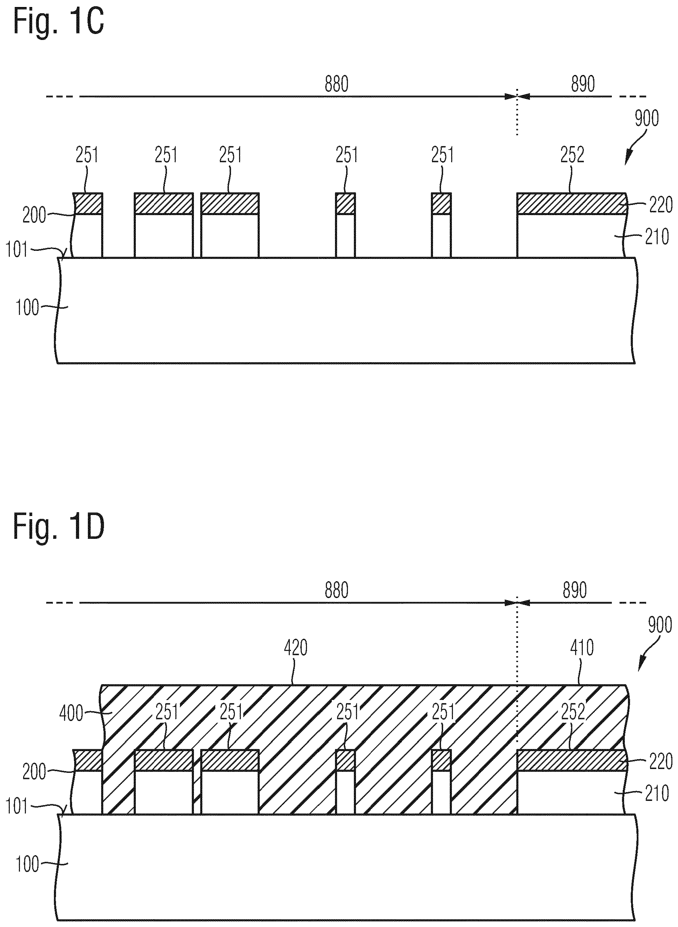

FIG. 1C shows the patterned layer stack 200 that includes a plurality of spatially isolated and electrically insulated first stack features 251 in the imaging region 880 and that may include second stack features 252, e.g. a frame-like second stack feature 252 that surrounds the imaging region 880. The second stack feature 252 may be continuous or may include several portions separated by non-printing gaps.

A photoresist layer 400 may be deposited that fills spaces between neighboring stack features 251, 252 and that covers the first and second stack features 251, 252, as shown in FIG. 1D. A photolithographic exposure process may selectively expose and harden a first resist portion 410 of the photoresist layer 400 in the frame region 890 or may selectively expose and degrade a second resist portion 420 in the imaging region 880.

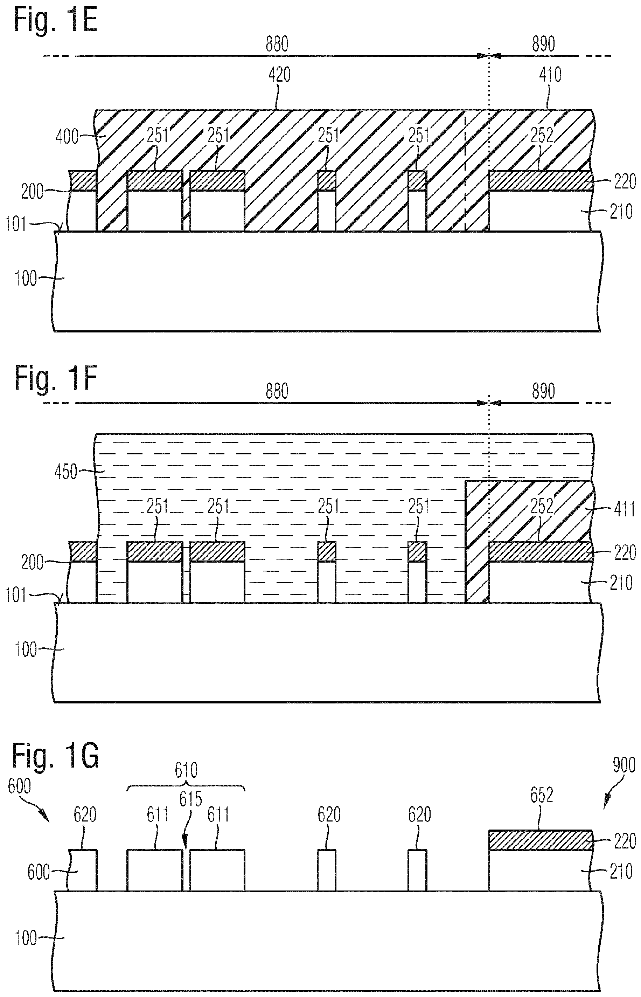

FIG. 1E shows the photoresist layer 400 after exposure. The second resist portion 420 in the imaging region 880 is better soluble in a developer solution than the first resist portion 410 in the frame region 890. The first resist portion 410 may overlap to some degree with the imaging region 880.

A developer solution 450 may be applied to the photomask 900 while the photomask 900 may rotate around a vertical spin axis through a horizontal center point of the photomask 900. For example, the photomask 900 may be fixed on a susceptor unit, e.g., by negative pressure generated by a vacuum chuck that rotates around the spin axis. While the photomask 900 is rotating, the developer solution 450 and a rinse liquid may be sequentially or alternatingly sprayed or dispensed onto the front side of the photomask 900.

According to another embodiment, the developer solution 450 may be deposited on a static photomask 900, wherein surface tension may hold the developer solution 450 in a puddle on the photomask 900. After causing a majority of the development to take place, the photomask 900 may start to rotate and more developer solution 450 and/or rinse liquid may be sprayed/dispensed onto the front surface of the photomask 900. For both cases, centrifugal forces drive the developer solution 450 from a central portion of the photomask 900 to the outer edge.

FIG. 1F shows the developer solution 450 selectively removing the second resist portion 420 of FIG. 1E from at least a portion of the imaging region 880. The developer solution 450 may contain TMAH (tetramethylammonium hydroxide, N(CH₃)₄⁺ OH⁻) and may be free of CO₂ or may contain CO₂ in solution. The rinse liquid may include DI (de-ionized water). During development and/or rinsing, the first stack features 251 in the imaging region 880 may get submerged in the developer solution 450 and/or rinse liquid. The first resist portion 410 may form a photoresist mask 411.

The flow of the developer solution 450 and/or the rinse liquid along the first stack features 251 may result in that the first stack features 251 may accumulate electric charge.

FIG. 1G shows the photomask 900 including a mask pattern 600 with a plurality of mask features and structures 610, 620 formed by exposed, spatially separated portions of the first mask layer 210 in the imaging region 880. The mask features and structures 610, 620 may shift the phase of exposure radiation that passes the mask features and structures 610, 620 by a predefined amount, for example by 90 degree or 180 degree. The frame region 890 includes a frame feature 650 that is significantly more opaque for the exposure radiation than the mask features and structures 610, 620.

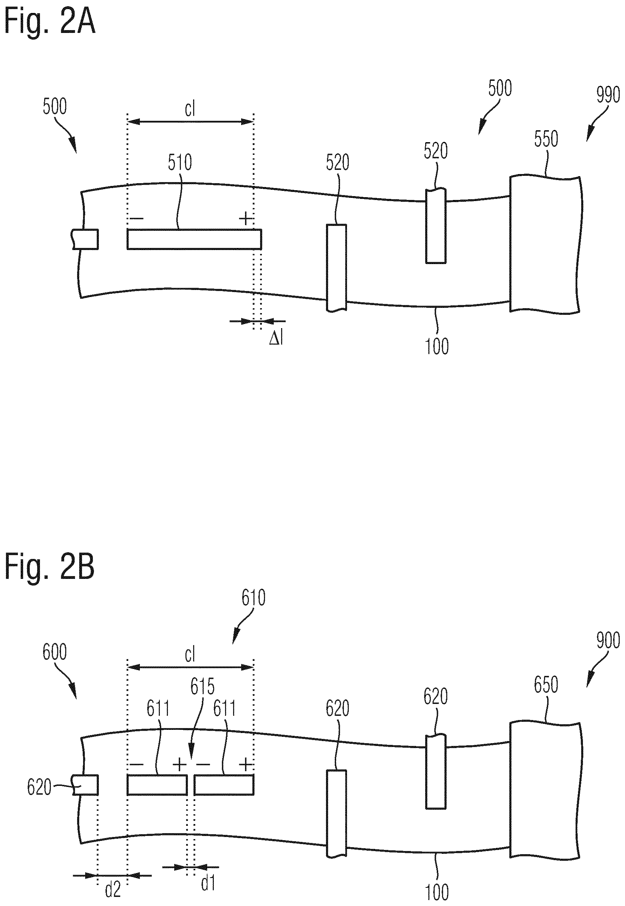

The mask pattern 600 includes at least one substitutional mask structure 610 that includes two segments 611 separated by a non-printing gap 615. The effect of the non-printing gap 615 is discussed with reference to FIGS. 2A and 2B.

FIG. 2A shows a portion of a comparative photomask 990 according to a comparative example including a first mask pattern 500 defined by first layout data.

The comparative photomask 990 may include one single imaging region 880 or a plurality of separated imaging regions 880, for example, two or four imaging regions 880. A frame region 890 surrounds each imaging region 880 and portions of the frame region 890 may separate neighboring imaging regions 880 from each other.

The first mask pattern 500 may include first mask features 510, 520 formed in the imaging region 880 and a frame feature 550 in the frame region 890. The first mask features 510, 520 are separated from each other and from the frame feature 550 by printing gaps. The first mask features 510, 520 may include a phase-shifting material that may be exposed or that may be covered with one or more other materials which are transparent for the exposure radiation.

At least one of the first mask features 510, 520 may be a critical mask feature 510 with a line-shaped portion exceeding a critical extension cl, e.g., a critical length. The critical length may depend, inter alia, on a minimum distance to a neighboring first mask feature 510, 520, on a mean distance to a center point of the comparative photomask 990, the horizontal cross-sectional area of the critical mask feature 510 and/or the orientation of the critical mask feature 510 with respect to a radial direction with reference to a horizontal center point.

During formation of the critical mask feature 510, a developer and/or a rinse process may cause electroforced migration of atoms in a direction towards a neighboring first mask feature 510, 520. The electroforced migration may deform the critical mask feature 510. For example, the critical mask feature 510 may be narrowed and/or shortened at one end and widened and/or elongated at an opposite end. The deformation of the critical mask feature 510 may transform in deformation of a target structure obtained by using the comparative photomask 990 in a lithography process for patterning semiconductor wafers.

FIG. 2B shows a portion of a photomask 900 according to the embodiments. The photomask 900 includes a second mask pattern 600 defined by second layout data, wherein in the second layout data the critical mask feature 510 of FIG. 2A is replaced with a substitutional mask structure 610 including at least two segments 611 and a non-printing gap 615 that separates the two segments 611. A length of each segment 611 may be at most 1 mm. A distance d1 between the segments 611 may be at most 50 nm.

The second mask pattern 600 may include non-critical mask features 620 that are identical with non-critical mask features 520 of the comparative photomask 990 of FIG. 2A. The photomask 900 may further include a frame feature 650 that is identical with the frame feature 550 of the comparative photomask 990 of FIG. 2A.

The combination of the at least two segments 611 and the non-printing gap 615 between them may enclose the horizontal contour of the critical mask feature 510 of FIG. 2A. Apart from optical assist features on both sides of the non-printing gap 615, a horizontal outline of the combination of the at least two segments 611 and the non-printing gap 615 between them may be identical with the horizontal contour of the critical mask feature of FIG. 2A. In particular, the total length of the substitutional mask structure 610 may be equal to the total length of the critical mask feature 510 in FIG. 2A.

Outer edges of the neighboring two segments 611 may be in alignment with each other such that linear projections of neighboring segments 611 into the non-printing gap 615 coincide.

The second mask features and structures 610, 620 may include a phase-shift material capable of shifting a phase of an exposure radiation passing the second mask features and structures 610, 620 by 180°, wherein a wavelength of the exposure radiation is 248 nm, 193 nm, 157 nm, or 146 nm.

The critical extension may be selected independently from the placement of a mask feature on the photomask, from a line-to-width ratio of the mask feature, from the contour of the mask feature and from a closest distance to a neighboring mask feature separated from the concerned mask feature by a printing gap. For example, a mask feature may be classified as critical mask feature and segmented by at least one non-printing gap if a length of any stripe portion of the mask feature exceeds 1 mm.

According to another embodiment a mask feature may be classified as critical mask feature if a ratio between a length of the mask feature and a width of a closest printing gap between the concerned mask feature and a neighboring mask feature exceeds 10000.

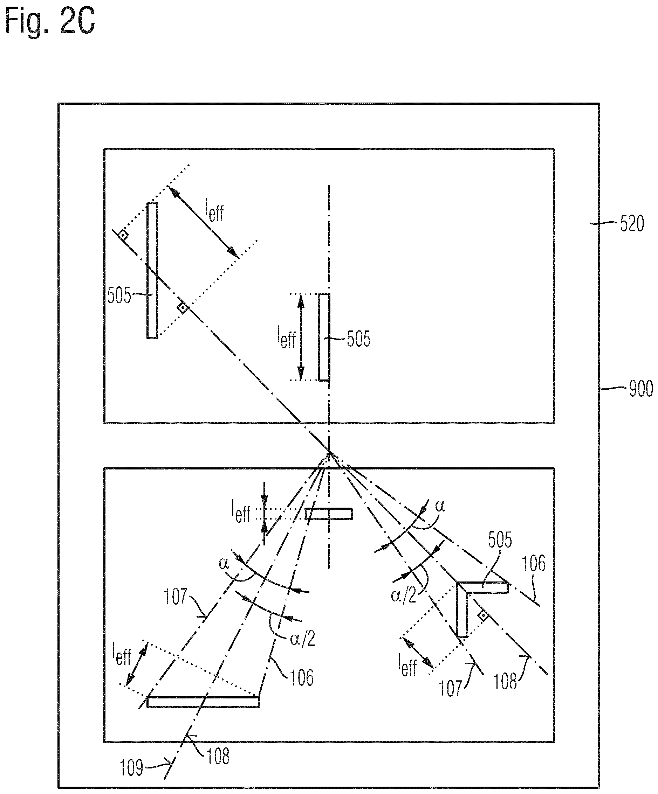

FIG. 2C refers to an embodiment with the critical extension defined by a linear radial extension leff, which is the length of a mask feature 505 projected onto a bisecting line 108 of a central angle α given by two radii 106, 107 defining a narrowest circular sector enclosing the mask feature 510. For each mask feature 505 of a first mask pattern 500 the linear radial extension leff may be calculated. If the linear radial extension leff exceeds a threshold value, the mask feature 505 may be classified as critical. The threshold value may depend on the distance to a horizontal center 905 of the photomask 900. The embodiment takes into account that the voltage that may be induced into a mask feature may change due to flow characteristics. Segmentation of mask features exceeding a certain length but not prone to electromigration due to their orientation may be avoided.

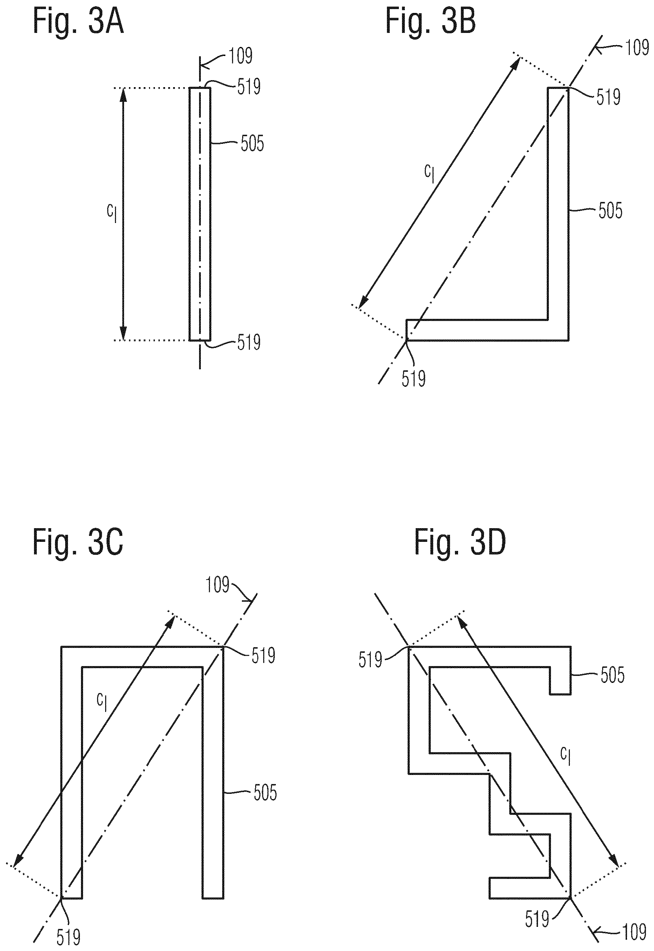

In FIGS. 3A to 3D the critical extension cl is defined as the extension along a horizontal direct line 109 connecting two uttermost points 519 of the mask features 510, wherein a distance between the two uttermost points 519 is not shorter than horizontal distances between any other points of the mask features 510.

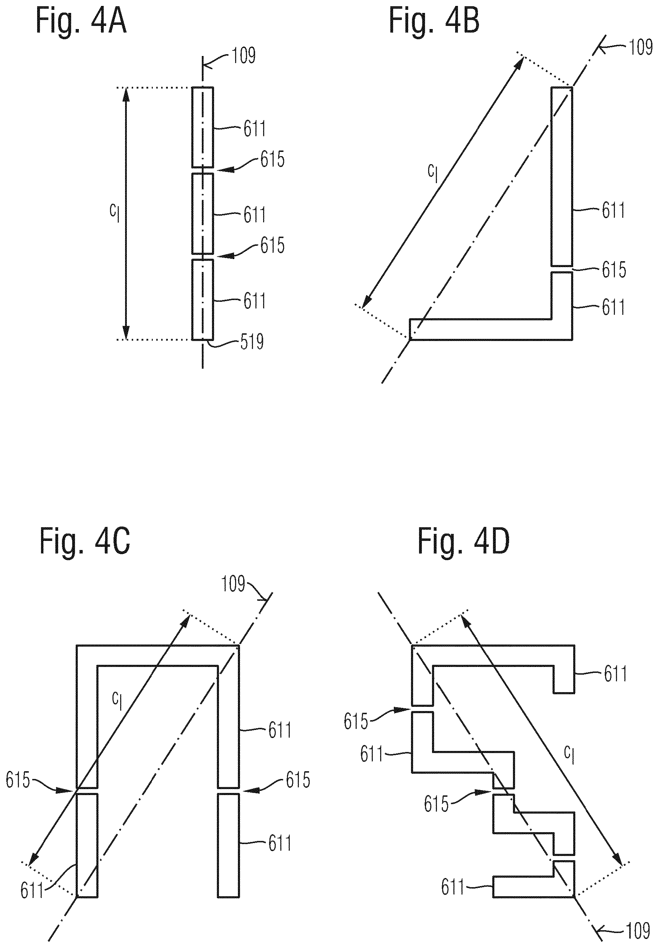

FIGS. 4A to 4D show substitutional mask structures 610 for the mask features 505 of FIGS. 3A to 3D.

According to another embodiment the critical extension cl may be the length of any straight line-shaped portions 515 of a mask feature 505. For example, in FIGS. 3A to 3D the length of each straight line-shaped portion of the mask features 505 may be separately evaluated and compared to a critical length.

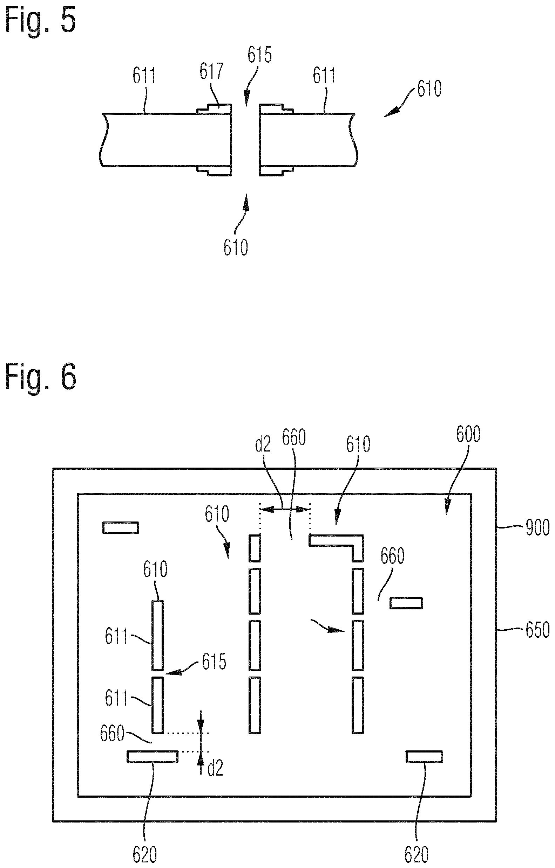

FIG. 5 shows two neighboring segments 611 of a substitutional mask structure 610. One of the segments or both may include correction features 617 close to the non-printing gap 615. For example, the correction features 617 may directly adjoin the non-printing gap 615. The correction features 617 may be symmetric with respect to a longitudinal center axis of the segments 611 and/or may be symmetric with respect to the non-printing gap 615. For example the correction features 617 may symmetrically widen end portions of the segments 611 by at least 10% and by at most 50%.

FIG. 6 shows a photomask 900 with a mask pattern 600 including mask features 620 and mask structures 610. A frame feature 650 may surround the mask pattern 600. Each mask structure 610 has at least two end points separated from neighboring mask features 620 and from neighboring mask structures 610 by printing gaps 660. For example, a minimum distance d2 between a mask structure 610 and a neighboring mask feature or structure 610, 620 is greater than 200 nm. A length of the segments 611 may be at most 1 mm. Each mask feature 620 may include at least two segments 611 separated by a non-printing gap 615. Outer edges of neighboring segments 611 may be in alignment with each other.

The mask features 620 and the mask structures 610 may include a phase-shift material capable of shifting a phase of an exposure radiation passing the photomask 900 by 180°, wherein a wavelength of the exposure radiation may be in a range from 146 nm to 248 nm.

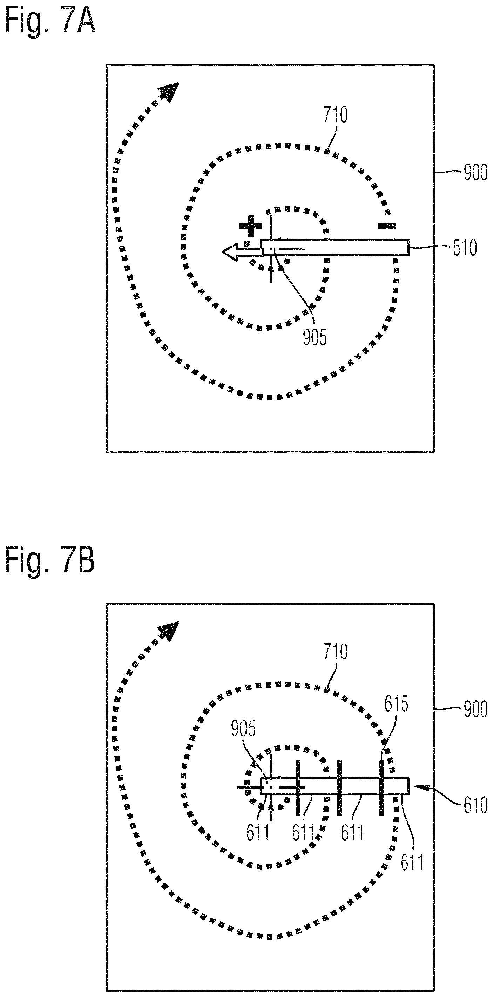

FIGS. 7A and 7B illustrate tracks 710 of a non-conductive or low-conductive liquid on a surface of rotating photomasks 990, 900, wherein the liquid may be a developer solution or a rinse liquid, by way of example. The tracks 710 may approximate spiral lines around horizontal center points 905 of the photomasks 990, 900 or radial tracks from the horizontal center points 905.

In FIG. 7A the flow of the liquid may result in a significant voltage drop between end points of a critical mask feature 510. A mean electric potential of the critical mask feature 510 may differ from a potential of a neighboring mask feature to such an degree such that an electric field strength between them is high enough to trigger electromigration in the critical mask feature 510 to an extent that deforms the outline of the critical mask feature 510.

In FIG. 7B the critical mask feature 510 of FIG 7A is replaced with a substitutional mask structure 610 including segments 611 separated by non-printing gaps 615. The flow of the liquid results in only insignificant voltage drops between end points of the segments 611. An electric field strength occurring between the segments 611 and other mask features is not high enough to trigger electromigration in the segments 611 to an extent that deforms the total outline of the substitutional mask structure 610.

According to another embodiment, a method of manufacturing a photomask may include forming a first mask pattern on a base substrate of the photomask, wherein the first mask pattern is formed from a layer stack. The layer stack includes at least a first layer formed on a first surface of a base substrate and a second layer formed on the first layer. Non-printing gaps are formed in mask features of the first mask pattern, wherein the non-printing gaps are arranged along grid lines of an orthogonal grid. The second layer is at least partially removed from the mask features. A distance between neighboring grid lines may be in a range from 200um to 1mm. The non-printing gaps may be formed simultaneously with or after the first mask pattern. The photomask, the first mask pattern, the layer stack, the first layer, the second layer, the base substrate, the mask features, the base substrate and/or the non-printing gaps may have any of the compositions, dimensions, arrangement and/or shapes as described for the preceding embodiments and Figures.

## Claims

1. A method of forming a photomask (900), comprising:
searching first layout data describing a first mask pattern (500) for a critical mask feature (510), wherein the critical mask feature (510) includes a line-shaped portion exceeding a critical length;
generating second layout data by replacing only the critical mask feature (510) with a substitutional mask structure (610), wherein the substitutional mask structure (610) comprises at least two segments (611) and a non-printing gap (615) separating the segments (611); and
forming a second mask pattern (600) described by the second layout data on a base substrate (100) of the photomask,
wherein the second mask pattern (600) is formed from a layer stack (200), wherein the layer stack (200) comprises at least a first layer (210) formed on a first surface (101) of a base substrate (100) and a second layer (220) formed on the first layer (210), and
wherein the first layer (210) comprises a phase-shift material capable of shifting a phase of an exposure radiation passing the first layer (210) by 180°, wherein a wavelength of the exposure radiation is in a range from 146 nm to 248 nm;
removing portions of the layer stack (200), wherein remnant portions of the layer stack (200) form a plurality of spatially and electrically separated first and second stack features (251, 252); and
removing remnant portions of the second layer (220) from the first stack features (251) using a photoresist mask (411) covering the at least one second stack feature (252).

2. The method of claim 1, wherein
the first layer (210) comprises molybdenum and silicon.

3. The method of claim 1, wherein
the second layer (220) comprises a conductive material with a transparency of less than 10% at an exposure radiation, wherein a wavelength of the exposure radiation is in a range from 146 nm to 248 nm.

4. The method of claim 1, wherein
the second layer (220) comprises chromium.

5. The method of claim 1, wherein
forming the photoresist mask (411) comprises applying a non-conductive or low-conductive liquid, wherein the liquid is transported in radial direction with respect to a horizontal center point of the photomask (900) and comes into contact with the first stack features (251).

6. The method of claim 1, wherein
the critical length is at least 1 mm.

7. The method of claim 1, wherein
a distance between the critical mask feature (510) and a closest neighboring mask feature (510, 520) is less than 200 nm.

8. The method of claim 1, wherein
at least one of the segments (611) comprises correction features (617) at a side oriented to the non-printing gap (615).

9. A photomask, comprising:
a mask pattern (600) that comprises mask features (620) and a mask structure (610), wherein the mask structure (610) comprises:
at least two end points separated from neighboring mask features (620) by printing gaps (660), and
a phase-shift material capable of shifting a phase of an exposure radiation passing the mask structure (610) by 180°, wherein a wavelength of the exposure radiation is in a range from 146 nm to 248 nm, wherein the phase-shift material is exposed at the top side or wherein the phase-shift material is covered with one or more other materials, which are transparent for the exposure radiation, **characterised in that**
a non-printing gap (615) separates the phase-shift material into two segments (611) only for critical mask features of **claim 1.**

10. The photomask of claim 9, wherein
parallel outer edges of neighboring segments (611) are in alignment.

11. The photomask of claim 9, wherein
a length of the segments (611) is at most 1 mm, and wherein a minimum distance between the mask structure (610) and neighboring mask features (620) is at least 200 nm.

12. A method of manufacturing a photomask (900), the method comprising:
forming a first mask pattern (500) on a base substrate (100) of the photo-mask, wherein the first mask pattern (500) is formed from a layer stack (200), the layer stack (200) comprising at least a first layer (210) formed on a first surface (101) of a base substrate (100) and a second layer (220) formed on the first layer (210), wherein the first layer (210) comprises a phase-shift material capable of shifting a phase of an exposure radiation passing the first layer (210) by 180°, wherein a wavelength of the exposure radiation is in a range from 146 nm to 248 nm;
forming non-printing gaps (615) in mask features (510) of the first mask pattern (500), wherein the non-printing gaps (615) are arranged along grid lines of an orthogonal grid; and
removing the second layer (220) from the mask features (510).

## Patentansprüche

1. Verfahren zum Bilden einer Fotomaske (900), aufweisend:
Durchsuchen von ersten Layoutdaten, die ein erstes Maskenmuster (500) beschreiben, nach einem kritischen Maskenmerkmal (510), wobei das kritische Maskenmerkmal (510) einen linienförmigen Bereich umfasst, der eine kritische Länge überschreitet;
Erzeugen von zweiten Layoutdaten durch Ersetzen nur des kritischen Maskenmerkmals (510) mit einer Ersatzmaskenstruktur (610), wobei die Ersatzmaskenstruktur (610) mindestens zwei Segmente (611) und einen nicht-abbildenden Spalt (615) aufweist, der die Segmente (611) trennt; und
Bilden eines zweiten Maskenmusters (600), das durch die zweiten Layoutdaten beschrieben wird, auf einem Basissubstrat (100) der Fotomaske,
wobei das zweite Maskenmuster (600) aus einem Schichtstapel (200) gebildet wird, wobei der Schichtstapel (200) mindestens eine erste Schicht (210), die auf einer ersten Oberfläche (101) eines Basissubstrats (100) gebildet ist, und eine zweite Schicht (220) aufweist, die auf der ersten Schicht (210) gebildet ist, und
wobei die erste Schicht (210) ein Phasenverschiebungsmaterial aufweist, das geeignet ist, eine Phase einer Belichtungsstrahlung, die die erste Schicht (210) passiert, um 180° zu verschieben, wobei eine Wellenlänge der Belichtungsstrahlung in einem Bereich von 146 nm bis 248 nm liegt;
Entfernen von Bereichen des Schichtstapels (200), wobei verbleibende Bereiche des Schichtstapels (200) eine Vielzahl von räumlich und elektrisch getrennten ersten und zweiten Stapelmerkmalen (251, 252) bilden; und
Entfernen verbleibender Bereiche der zweiten Schicht (220) von den ersten Stapelmerkmalen (251) unter Verwendung einer Fotolackmaske (411), die das mindestens eine zweite Stapelmerkmal (252) bedeckt.

2. Verfahren nach Anspruch 1, wobei
die erste Schicht (210) Molybdän und Silizium aufweist.

3. Verfahren nach Anspruch 1, wobei
die zweite Schicht (220) ein leitfähiges Material mit einer Transparenz von weniger als 10% bei einer Belichtungsstrahlung aufweist, wobei eine Wellenlänge der Belichtungsstrahlung in einem Bereich von 146 nm bis 248 nm liegt.

4. Verfahren nach Anspruch 1, wobei
die zweite Schicht (220) Chrom aufweist.

5. Verfahren nach Anspruch 1, wobei
das Bilden der Fotolackmaske (411) das Aufbringen einer nicht leitenden oder schwach leitenden Flüssigkeit aufweist, wobei die Flüssigkeit in radialer Richtung in Bezug auf einen horizontalen Mittelpunkt der Fotomaske (900) transportiert wird und mit den ersten Stapelmerkmalen (251) in Kontakt kommt.

6. Verfahren nach Anspruch 1, wobei
die kritische Länge mindestens 1 mm beträgt.

7. Verfahren nach Anspruch 1, wobei
ein Abstand zwischen dem kritischen Maskenmerkmal (510) und einem nächsten benachbarten Maskenmerkmal (510, 520) weniger als 200 nm beträgt.

8. Verfahren nach Anspruch 1, wobei
mindestens eines der Segmente (611) Korrekturmerkmale (617) an einer Seite aufweist, die zu dem nicht-abbildenden Spalt (615) ausgerichtet ist.

9. Fotomaske, aufweisend:
ein Maskenmuster (600), das Maskenmerkmale (620) und eine Maskenstruktur (610) aufweist, wobei die Maskenstruktur (610) aufweist:
mindestens zwei Endpunkte, die von benachbarten Maskenmerkmalen (620) durch Druckspalte (660) getrennt sind, und
ein Phasenverschiebungsmaterial, das geeignet ist, eine Phase einer Belichtungsstrahlung, die die Maskenstruktur (610) passiert, um 180° zu verschieben, wobei eine Wellenlänge der Belichtungsstrahlung in einem Bereich von 146 nm bis 248 nm liegt, wobei das Phasenverschiebungsmaterial an der Oberseite belichtet wird oder wobei das Phasenverschiebungsmaterial mit einem oder mehreren anderen Materialien bedeckt ist, die für die Belichtungsstrahlung transparent sind, **dadurch gekennzeichnet, dass**
ein nicht-abbildender Spalt (615) das Phasenverschiebungsmaterial in zwei Segmente (611) nur für kritische Maskenmerkmale nach Anspruch 1 trennt.

10. Fotomaske nach Anspruch 9, wobei
parallele Außenkanten benachbarter Segmente (611) ausgerichtet sind.

11. Fotomaske nach Anspruch 9, wobei
eine Länge der Segmente (611) höchstens 1 mm beträgt, und wobei ein minimaler Abstand zwischen der Maskenstruktur (610) und benachbarten Maskenmerkmalen (620) mindestens 200 nm beträgt.

12. Verfahren zum Herstellen einer Fotomaske (900), wobei das Verfahren aufweist:
Bilden eines ersten Maskenmusters (500) auf einem Basissubstrat (100) der Fotomaske, wobei das erste Maskenmuster (500) aus einem Schichtstapel (200) gebildet wird, wobei der Schichtstapel (200) mindestens eine erste Schicht (210), die auf einer ersten Oberfläche (101) eines Basissubstrats (100) gebildet ist, und eine zweite Schicht (220) aufweist, die auf der ersten Schicht (210) gebildet ist, wobei die erste Schicht (210) ein Phasenverschiebungsmaterial aufweist, das geeignet ist, eine Phase einer Belichtungsstrahlung, die die erste Schicht (210) passiert, um 180° zu verschieben, wobei eine Wellenlänge der Belichtungsstrahlung in einem Bereich von 146 nm bis 248 nm liegt;
Bilden von nicht-abbildenden Spalten (615) in Maskenmerkmalen (510) des ersten Maskenmusters (500), wobei die nicht-abbildenden Spalten (615) entlang Gitterlinien eines orthogonalen Gitters angeordnet sind; und
Entfernen der zweiten Schicht (220) von den Maskenmerkmalen (510).

## Revendications

1. Procédé de formation d'un photomasque (900), comprenant :
la recherche de premières données de disposition décrivant un premier motif de masque (500) pour une caractéristique de masque critique (510), dans lequel la caractéristique de masque critique (510) comporte une portion en forme de ligne dépassant une longueur critique ;
la génération de secondes données de disposition en remplaçant uniquement la caractéristique de masque critique (510) par une structure de masque de substitution (610), dans lequel la structure de masque de substitution (610) comprend au moins deux segments (611) et un espace de non-impression (615) séparant les segments (611) ; et
la formation d'un second motif de masque (600) décrit par les secondes données de disposition sur un substrat de base (100) du photomasque,
dans lequel le second motif de masque (600) est formé à partir d'un empilement de couches (200), dans lequel l'empilement de couches (200) comprend au moins une première couche (210) formée sur une première surface (101) d'un substrat de base (100) et une seconde couche (220) formée sur la première couche (210), et
dans lequel la première couche (210) comprend un matériau de décalage de phase capable de décaler de 180° une phase d'un rayonnement d'exposition traversant la première couche (210), dans lequel une longueur d'onde du rayonnement d'exposition est dans une plage de 146 nm à 248 nm ;
l'élimination de portions de l'empilement de couches (200), dans lequel des portions restantes de l'empilement de couches (200) forment une pluralité de première et seconde caractéristiques d'empilement (251, 252) séparées spatialement et électriquement ; et
l'élimination de portions restantes de la seconde couche (220) à partir des premières caractéristiques d'empilement (251) à l'aide d'un masque de résine photosensible (411) recouvrant ladite au moins une seconde caractéristique d'empilement (252).

2. Procédé selon la revendication 1, dans lequel
la première couche (210) comprend du molybdène et du silicium.

3. Procédé selon la revendication 1, dans lequel
la seconde couche (220) comprend un matériau conducteur ayant une transparence inférieure à 10 % à un rayonnement d'exposition, dans lequel une longueur d'onde du rayonnement d'exposition est dans une plage de 146 nm à 248 nm.

4. Procédé selon la revendication 1, dans lequel
la seconde couche (220) comprend du chrome.

5. Procédé selon la revendication 1, dans lequel
la formation du masque de résine photosensible (411) comprend l'application d'un liquide non conducteur ou faiblement conducteur, dans lequel le liquide est transporté dans une direction radiale par rapport à un point central horizontal du photomasque (900) et entre en contact avec les premières caractéristiques d'empilement (251).

6. Procédé selon la revendication 1, dans lequel
la longueur critique est d'au moins 1 mm.

7. Procédé selon la revendication 1, dans lequel
une distance entre la caractéristique de masque critique (510) et une caractéristique de masque (510, 520) voisine la plus proche est inférieure à 200 nm.

8. Procédé selon la revendication 1, dans lequel
au moins l'un des segments (611) comprend des caractéristiques de correction (617) sur un côté orienté vers l'espace de non-impression (615).

9. Photomasque, comprenant :
un motif de masque (600) qui comprend des caractéristiques de masque (620) et une structure de masque (610), dans lequel la structure de masque (610) comprend :
au moins deux points d'extrémité séparés de caractéristiques de masque (620) voisines par des espaces d'impression (660), et
un matériau de décalage de phase capable de décaler de 180° une phase d'un rayonnement d'exposition traversant la structure de masque (610), dans lequel une longueur d'onde du rayonnement d'exposition est dans une plage de 146 nm à 248 nm, dans lequel le matériau de décalage de phase est exposé sur le côté supérieur ou dans lequel le matériau de décalage de phase est recouvert d'un ou plusieurs autres matériaux, qui sont transparents vis-à-vis du rayonnement d'exposition, **caractérisé en ce qu'**un espace de non-impression (615) sépare le matériau de décalage de phase en deux segments (611) uniquement pour des caractéristiques de masque critiques selon la revendication 1.

10. Photomasque selon la revendication 9, dans lequel
des bords extérieurs parallèles de segments (611) voisins sont alignés.

11. Photomasque selon la revendication 9, dans lequel
une longueur des segments (611) est d'au plus 1 mm, et dans lequel une distance minimale entre la structure de masque (610) et les caractéristiques de masque (620) voisines est d'au moins 200 nm.

12. Procédé de fabrication d'un photomasque (900), le procédé comprenant :
la formation d'un premier motif de masque (500) sur un substrat de base (100) du photo-masque, dans lequel le premier motif de masque (500) est formé à partir d'un empilement de couches (200), l'empilement de couches (200) comprenant au moins une première couche (210) formée sur une première surface (101) d'un substrat de base (100) et une seconde couche (220) formée sur la première couche (210), dans lequel la première couche (210) comprend un matériau de décalage de phase capable de décaler de 180° une phase d'un rayonnement d'exposition traversant la première couche (210), dans lequel une longueur d'onde du rayonnement d'exposition est dans une plage de 146 nm à 248 nm ;
la formation d'espaces de non-impression (615) dans des caractéristiques de masque (510) du premier motif de masque (500), dans lequel les espaces de non-impression (615) sont agencés le long de lignes de grille d'une grille orthogonale ; et
l'élimination de la seconde couche (220) à partir des caractéristiques de masque (510).
